# EUROPEAN PATENT APPLICATION

(11) **EP 0 996 188 A2**
(43) Date of publication of application: **26.04.2000**
(21) Application number: 99121183.0
(22) Date of filing: 22.10.1999
(51) Int. Cl.: H01P 1/387, H01P 7/10, H01P 11/00

(54) **Microwave-millimeter wave circuit apparatus and fabrication method thereof having a circulator or isolator**

(30) Priority: 23.10.1998 JP 30276798
(71) Applicant: NEC CORPORATION, Tokyo (JP)
(72) Inventor: Ohata, Keiichi, Minato-ku, Tokyo (JP); Maruhashi, Kenichi, Minato-ku, Tokyo (JP)
(74) Representative: Glawe, Delfs, Moll & Partner

(57) **Abstract**

Circuits having active devices, a pattern for a circulator or isolator, and ferrite are formed on a semiconductor microwave - millimeter wave circuit substrate. The ferrite is embedded in a dielectric substrate. The dielectric substrate is oppositely aligned with the semiconductor microwave - millimeter wave circuit substrate having the pattern for the circulator or the like. Thus, the pattern is coupled with the ferrite so as to structure the circulator or isolator.

## Description

### Background of the Invention

### 1. Field of the Invention

The present invention relates to a microwave - millimeter wave circuit apparatus, in particular, to a microwave - millimeter wave circuit apparatus having a circulator or isolator and a fabrication method thereof.

### 2. Description of the Related Art

A front end module and an amplifier for a microwave - millimeter wave band radio apparatus use a circulator or isolator so that a transmitter signal and a receiver signal (or an input signal and an output signal) are properly separated so as to prevent each inducement.

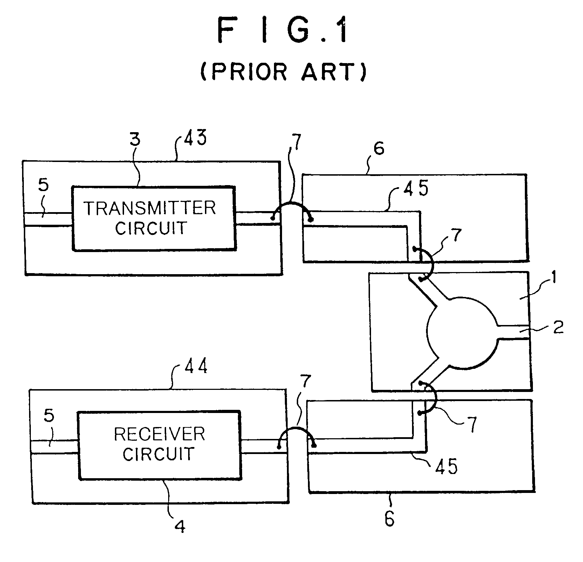

Fig. 1 shows an example of the structure of a conventional RF front-end module. The conventional RF front-end module is composed of a substrate type circulator 1, a transmitter circuit substrate 43, a receiver circuit substrate 44, and a connection substrate 6. The transmitter circuit substrate 43 has a transmitter circuit 3 formed thereon. The receiver circuit substrate 44 has a receiver circuit 4 formed thereon. The connection substrate 6 has a connection line pattern 45 formed thereon.

The substrate type circulator 1 is structured as a circulator using for example ferrite. A permanent magnet (not shown) is disposed outside the substrate type circulator 1. The transmitter circuit 3 and the receiver circuit 4 are composed of for example MMICs (Monolithic Microwave Integrated Circuits). The connection line pattern 45 is composed of micros-trip lines formed on for example an alumina substrate. Each of the transmitter circuit 3 and the receiver circuit 4 has an internal local oscillation circuit. Alternatively, an external local oscillation signal may be supplied to each of the transmitter circuit 3 and the receiver circuit 4 through relevant terminals. The individual substrates are connected with bonding wires 7. In Fig. 1, reference numeral 5 is an IF signal terminal; and reference numeral 2 is an RF signal terminal connected to an antenna (not shown). The substrate type circulator 1 separates an output portion of the transmitter circuit 3 from an input portion of the receiver circuit 4 through the RF signal terminal 2 connected to the antenna.

In such a conventional microwave - millimeter wave circuit apparatus, by controlling an external magnetic field applied to the ferrite of the substrate type circulator 1, the characteristic of the apparatus is adjusted.

In the above-described conventional microwave - millimeter wave circuit apparatus having the circulator or isolator, individual circuits are formed on respective substrates and the substrates are connected with bonding wires. Thus, even if the transmitter circuit and the receiver circuit are structured with MMICs for size reduction, mass production, and cost reduction, since the circulator or isolator is another part, it should be separately assembled and adjusted as a discrete part. Thus, when the microwave - millimeter wave circuit apparatus is used for the front-end module or the like, it is difficult to reduce the size and cost of the apparatus, mass-produce the apparatus, and rigidify the apparatus. In addition, since the circulator or isolator should be separately adjusted, it is difficult to accomplish the reproducibility of the performance of the apparatus. In addition, since the apparatus requires an external magnet, it is difficult to reduce the size of the apparatus.

### Summary of the Invention

The present invention is made from the above-described point of view. An object of the present invention is to provide a microwave - millimeter wave circuit apparatus having a circulator or isolator, the apparatus being compact, fabricated at low cost, and suitable for mass production. Another object of the present invention is to provide a method for fabricating such an apparatus.

A first aspect of the present invention is a microwave - millimeter wave circuit apparatus, comprising an MMIC (Monolithic Microwave Integrated Circuits) substrate having a microwave - millimeter wave circuit and a pattern for a circulator or isolator, the microwave - millimeter wave circuit and the pattern being formed on the MMIC substrate, the pattern being connected to the microwave - millimeter wave circuit.

A second aspect of the present invention is a microwave - millimeter wave circuit apparatus, comprising a circuit substrate having a microwave - millimeter wave circuit formed thereon, wherein a pattern for a circulator or isolator connected to the microwave - millimeter wave circuit is formed on the circuit substrate, ferrite composing the circulator or isolator contacting the pattern.

A third aspect of the present invention is a method for fabricating a microwave - millimeter wave circuit apparatus, comprising the steps of forming a microwave - millimeter wave circuit having a pattern for a circulator or isolator on a first surface of an MMIC substrate, forming a ferrite layer in such a manner that the ferrite layer contacts the pattern for the circulator or isolator, and forming a grounding metal layer on a second surface of the MMIC substrate.

A fourth aspect of the present invention is a microwave - millimeter wave circuit apparatus, comprising a dielectric substrate having ferrite composing a circulator or isolator, the ferrite being embedded in the dielectric substrate, and a circuit substrate having a microwave - millimeter wave circuit formed thereon, wherein the dielectric substrate and the circuit substrate are oppositely aligned in such a manner that the microwave - millimeter wave circuit and the circulator or isolator are integrally structured.

A fifth aspect of the present invention is a microwave - millimeter wave circuit apparatus, comprising a circuit substrate having a microwave - millimeter wave circuit including an oscillation circuit, the microwave - millimeter wave circuit being formed on the circuit substrate, and a dielectric substrate having ferrite and a dielectric resonator embedded therein, the ferrite composing a circulator or isolator, the dielectric resonator being a resonating circuit, wherein the circuit substrate and the dielectric substrate are oppositely aligned in such a manner that the microwave - millimeter wave circuit, the resonating circuit, and the circulator or isolator are integrally structured.

These and other objects, features and advantages of the present invention will become more apparent in light of the following detailed description of a best mode embodiment thereof, as illustrated in the accompanying drawings.

### Brief Description of Drawings

Fig. 1 is a plan view showing the structure of a conventional microwave - millimeter wave circuit apparatus;
Figs. 2A and 2B are a plan view and a sectional view showing an example of the structure of a microwave - millimeter wave circuit apparatus according to a first embodiment of the present invention;
Figs. 3A and 3B are a plan view and a sectional view showing another example of the structure of the microwave - millimeter wave circuit apparatus according to the first embodiment of the present invention;
Figs. 4A to 4F are sectional views showing fabrication steps of the microwave - millimeter wave circuit apparatus shown in Figs. 2A and 2B;
Figs. 5A to 5F are sectional views showing fabrication steps of the microwave - millimeter wave circuit apparatus shown in Figs. 3A and 3B;
Figs. 6A and 6B are a plan view and a sectional view showing a first example of the structure of a microwave - millimeter wave circuit apparatus according to a second embodiment of the present invention;
Figs. 7A and 7B are a plan view and a sectional view showing a second example of the structure of the microwave - millimeter wave circuit apparatus according to the second embodiment of the present invention;
Figs. 8A and 8B are a plan view and a sectional view showing a third example of the structure of the microwave - millimeter wave circuit apparatus according to the second embodiment of the present invention;
Figs. 9A and 9B are a plan view and a sectional view showing a fourth example of the structure of the microwave - millimeter wave circuit apparatus according to the second embodiment of the present invention;
Figs. 10A and 10B are a plan view and a sectional view showing an example of the structure of the microwave - millimeter wave circuit apparatus according to a third embodiment of the present invention;
Figs. 11A and 11B are a plan view and a sectional view showing another example of the structure of the microwave - millimeter wave circuit apparatus according to the third embodiment of the present invention;
Figs. 12A and 12B are a plan view and a sectional view showing an example of the structure of a microwave - millimeter wave circuit apparatus according to a fourth embodiment of the present invention;
Figs. 13A and 13B are a plan view and a sectional view showing another example of the structure of the microwave - millimeter wave circuit apparatus according to the fourth embodiment of the present invention; and
Figs. 14A and 14B are a plan view and a sectional view showing the structure according to an embodiment of the present invention of which an active circuit and an isolator are formed on the same substrate.

### Description of Preferred Embodiments

### [First Embodiment]

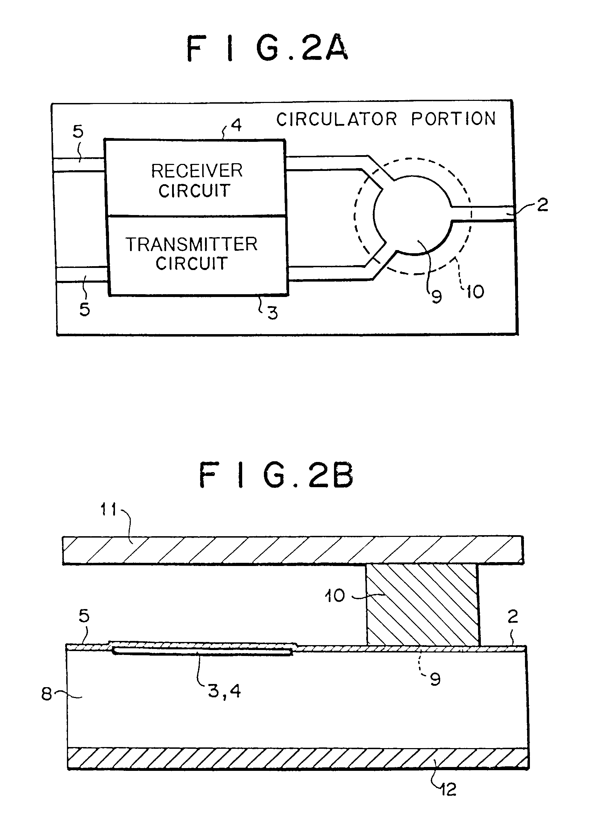

Figs. 2A and 2B are a plan view and a sectional view showing an example of the structure of a microwave - millimeter wave circuit apparatus according to a first embodiment of the present invention. Referring to Figs. 2A and 2B, a transmitter circuit 3 and a receiver circuit 4 are formed on an MMIC substrate 8. In addition, a pattern 9 for a circulator is formed on the MMIC substrate 8. One surface of ferrite 10 contacts the pattern 9. A grounding metal layer or a metal cover 11 is disposed on the other surface of the ferrite. A grounding metal layer 12 is formed on the other surface of the MMIC substrate 8. In the first embodiment, lines of the circulator are of tri-plate type of which a signal line is formed between the ferrite and the MMIC substrate 8 having a grounding metal layer 12 and between the metal cover 11 and the ferrite. The transmitter circuit 3 has a power amplifying circuit, a radio frequency converter, and a modulating circuit. The receiver circuit 4 has a radio frequency amplifying circuit, a mixer, an intermediate frequency amplifying circuit, and a demodulating circuit. The receiver circuit 4 outputs a base band signal. The MMIC substrate 8 is for example a GaAs substrate, an InP substrate, or a SiC substrate.

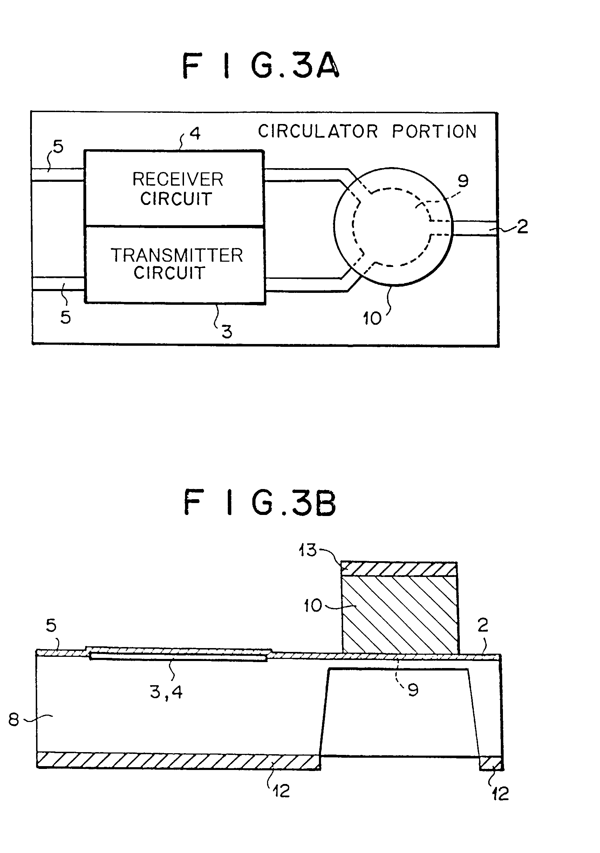

Figs. 3A and 3B are a plan view and a sectional view showing another example of the structure of the microwave - millimeter wave circuit apparatus according to the first embodiment of the present invention. As with the structure shown in Figs. 2A and 2B, the microwave - millimeter wave circuit apparatus shown in Figs. 3A and 3B is composed of an MMIC substrate 8, ferrite 10, and a grounding metal 12. A transmitter circuit 3, a receiver circuit 4, and a pattern 9 for a circulator are formed on the MMIC substrate 8. In the MMIC substrate 8, a portion corresponding to the ferrite 10 is thinned. Lines of the circulator are of micro-strip type. Since the electric field concentrates at the thinned portion of the MMIC substrate 8, a proper transmitter mode can be accomplished as the micro-strip lines. Thus, a good characteristic of the circulator can be obtained. Alternatively, a coplanar waveguide may be formed on the MMIC substrate 8. The coplanar waveguide is composed of a center line, a left grounding line, and a right grounding line formed on one surface of the MMIC substrate 8. In this case, the frequency dispersion is suppressed in comparison with the structure using the micro-strip lines.

As are clear from Figs. 2A, 2B, 3A, and 3B, according to the first embodiment, since the pattern for the circulator is formed on the MMIC substrate, by disposing the ferrite 10 on the MMIC substrate, a compact microwave - millimeter wave front end module having a circulator can be easily accomplished.

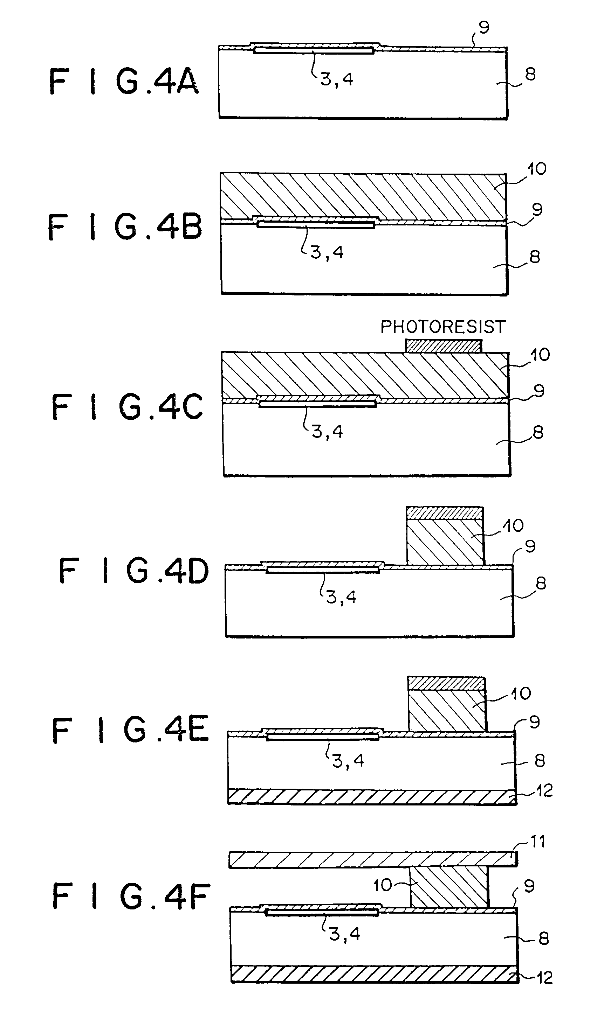

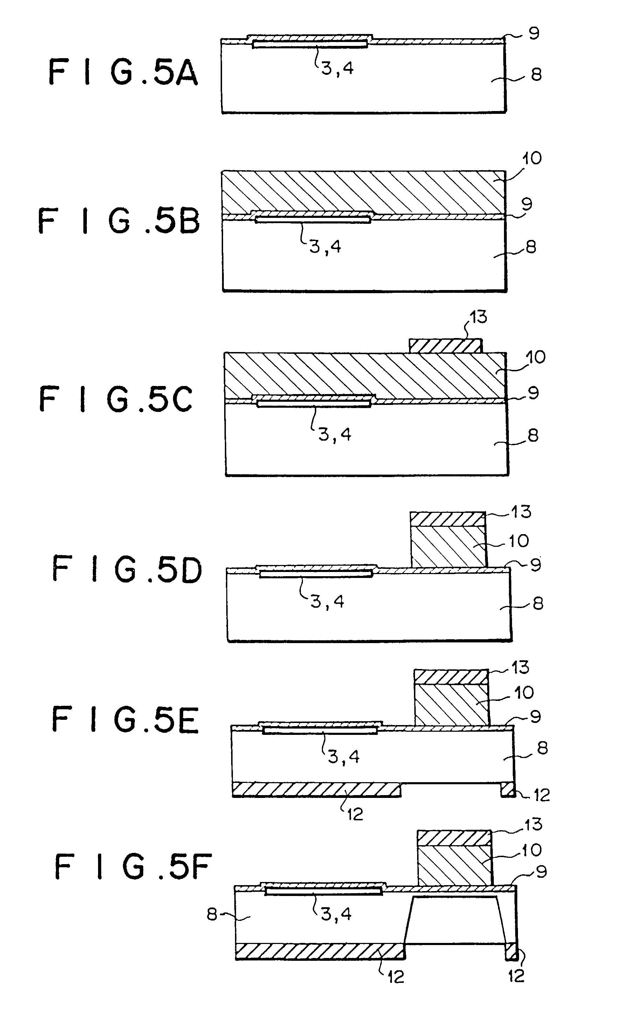

Figs. 4A to 4F and 5A to 5F show fabrication steps of the microwave - millimeter wave circuit apparatus shown in Figs. 2A, 2B, 3A, and 3B according to the first embodiment of the present invention. In these drawings, only one chip is shown. However, it should be noted that since MMIC fabrication process is used, many microwave - millimeter wave circuit apparatus arranged horizontally can be fabricated at a time.

The microwave - millimeter wave circuit apparatus shown in Figs. 2A and 2B are fabricated at fabrication steps shown in Figs. 4A to 4F. First of all, a transmitter circuit portion 3, a receiver circuit portion 4, and a gold-plated pattern 9 for a circulator are formed on an MMIC substrate 8 at a wiring step of an MMIC fabrication process (at step (a)). Thereafter, a ferrite layer 10 is formed in such a manner that it contacts the pattern for the circulator by for example spattering method (at step (b)). Photoresist is coated corresponding to the pattern for the circulator on the ferrite layer and exposed. Thereafter, the photoresist is removed and thereby the pattern for the circulator is formed (at step (c)). With a mask of the photoresist, the ferrite is patterned by dry-etching method (at step (d)). By abrading the bottom of the MMIC substrate, the thickness of the MMIC substrate is adjusted. Thereafter, a grounding metal layer 12 is formed on the lower surface of the MMIC substrate (at step (e)). After the photoresist 13 is removed, a metal cover 11 is formed on the ferrite (at step (f)).

The microwave - millimeter wave circuit apparatus shown in Figs. 3A and 3B are fabricated at steps shown in Figs. 5A to 5F. A transmitter circuit portion 3, a receiver circuit portion 4, and a gold-plated pattern 9 for a circulator are formed on an MMIC substrate 8 by a wiring step of an MMIC fabrication process (at step (a)). Thereafter, a ferrite layer 10 is formed in such a manner that it contacts the pattern for the circulator by for example spattering method (at step (b)). In addition, a grounding metal layer 13 is formed corresponding to the pattern 9 for the circulator on the ferrite layer by titanium - gold spattering method and gold plating method (at step (c)). With a mask of the grounding metal layer 13, the ferrite is patterned by for example dry-etching method (at step (d)). By abrading the bottom portion of the MMIC substrate, the thickness thereof is adjusted. Thereafter, a grounding metal layer is formed on the bottom of the MMIC substrate. A grounding metal 12 is patterned corresponding to the pattern for the circulator by for example dry-etching method (at step (e)). When necessary, the bottom portion of the MMIC substrate corresponding to the pattern for the circulator is thinned by dry-etching method. Thus, the circulator is formed (at step (f)).

According to the first embodiment, a GaAs substrate is used as the MMIC substrate. With a 0.15 µm gate AlGaAs/InGaAs hetero-junction FET as an active device, lines for the transmitter circuit, the receiver circuit, and the circulator are formed. Thus, an MMIC chip can be accomplished. As an example of the material of the ferrite, Ni-Zn type spinel soft ferrite can be used. When Sr/Br magnetoplumbite hard ferrite is used as the material of the ferrite, since it has self coercive force, the external magnet can be omitted. Thus, the size of the apparatus can be further reduced.

### [Second Embodiment]

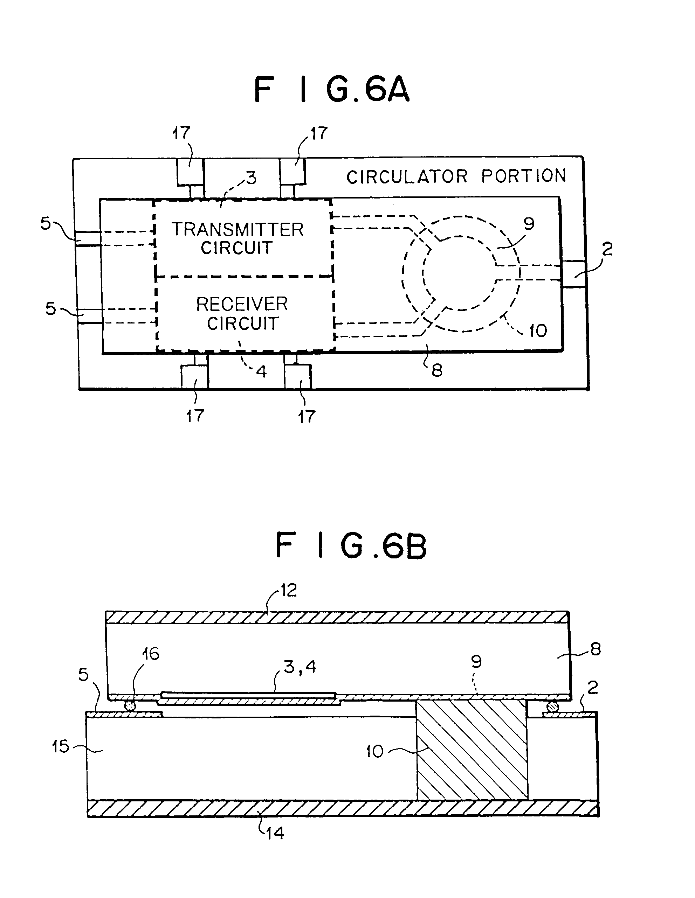

Figs. 6A and 6B are a plan view and a sectional view showing a first example of the structure of a microwave - millimeter wave circuit apparatus according to a second embodiment of the present invention. The microwave - millimeter wave circuit apparatus shown in Figs. 6A and 6B is composed of an MMIC substrate 8 and a dielectric substrate 15. A transmitter circuit 3, a receiver circuit 4, and a pattern 9 for a circulator are formed on the MMIC substrate 8. Ferrite 10 for a circulator is embedded in the dielectric substrate 15. The dielectric substrate 15 is for example a glass ceramic substrate. The MMIC substrate 8 and the dielectric substrate 15 are oppositely aligned. The dielectric substrate 15 has an RF signal terminal 2, an IF signal terminal 5, and a bias terminal 17. The transmitter circuit 3, the receiver circuit 4, and the pattern 9 for the circulator formed on the MMIC substrate 8 are connected with bumps 16. The ferrite 10 and the pattern 9 are oppositely aligned in such a manner that the ferrite 10 contacts the pattern 9. Thus, the transmitter circuit, the receiver circuit, and the circulator are integrally structured. In the structure shown in Figs. 6A and 6B, the MMIC substrate 8 is mounted on the dielectric substrate 15 by flip-chip method using the bumps 16. An RF signal terminal 2, an IF signal terminal 5, and a bias terminal 17 are disposed on the dielectric substrate 15. Lines for the circulator are of tri-plate type. In the structure shown in Figs. 6A and 6B, since the two substrates are connected with the bumps 16, the connections are made in the minimum distance. Thus, the reproducibility of the characteristic of the apparatus is excellent. In addition, since the terminal connections can be performed at a time, the apparatus is suitable for mass production. When a gap is formed between the MMIC substrate 8 and the dielectric substrate 15, the circuit characteristic of the MMIC substrate 8 can be prevented from varying.

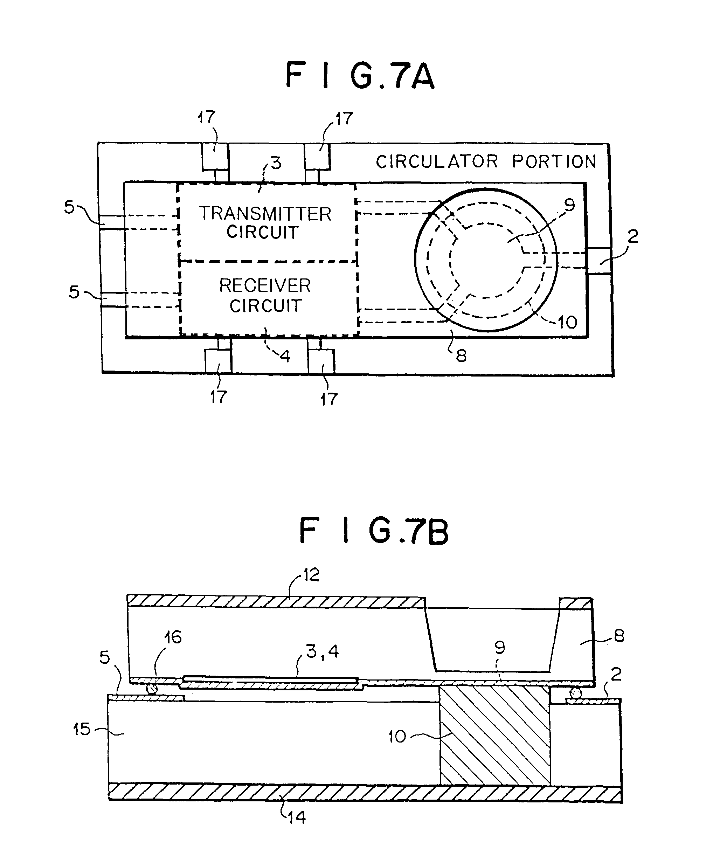

Figs. 7A and 7B are a plan view and a sectional view showing a second example of the structure of the microwave - millimeter wave circuit apparatus according to the second embodiment. In the structure shown in Figs. 7A and 7B, in an MMIC substrate 8, a portion corresponding to ferrite 10 is thinned. Lines for a circulator are of micro strip type.

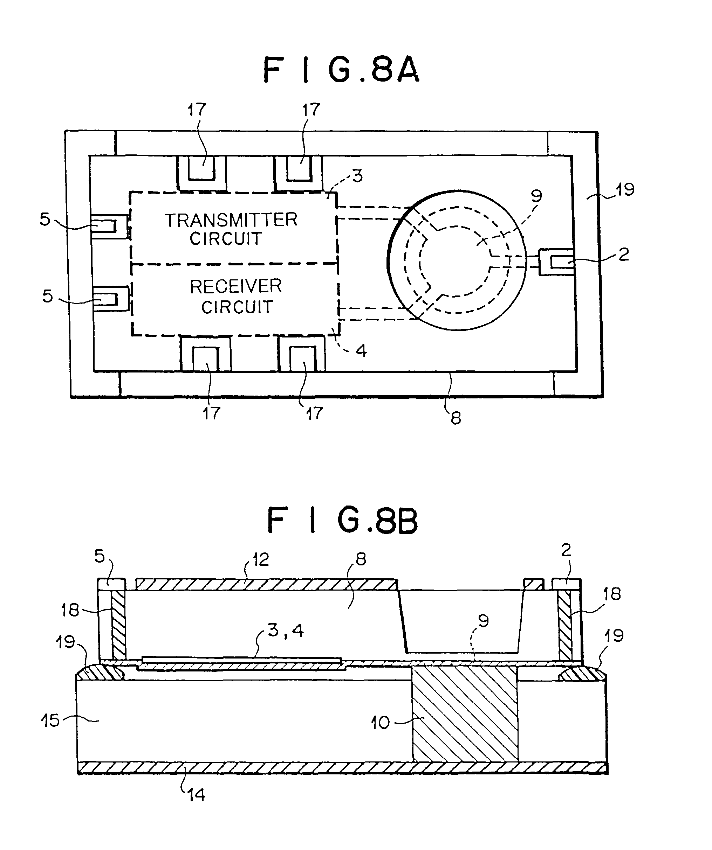

Figs. 8A and 8B are a plan view and a sectional view showing a third example of the structure of the microwave -millimeter wave circuit apparatus according to the second embodiment of the present invention. In the structure shown in Figs. 8A and 8B, an RF signal terminal 2, IF signal terminals 5, and bias terminals 17 for the transmitter circuit 3 and the receiver circuit 4 are disposed on the back surface of an MMIC substrate 8. Via-holes 18 are formed in the MMIC substrate 8. A line pattern 9 and so forth for a microwave - millimeter wave circuit of the MMIC substrate 8 are connected to a dielectric substrate 8 with the via-holes 18 as shown in Fig. 8B. The MMIC substrate 8 is oppositely adhered to the dielectric substrate 15 with thermal conductivity resin or photo-setting resin 19. Thus, the MMIC substrate 8 and the dielectric substrate 15 are integrally structured. As described above, a gap formed between the MMIC substrate 8 and the dielectric substrate 15 contributes to the stability of the characteristic of the apparatus. In addition, when the gap is filled with resin, a very rigid microwave - millimeter wave circuit apparatus can be accomplished.

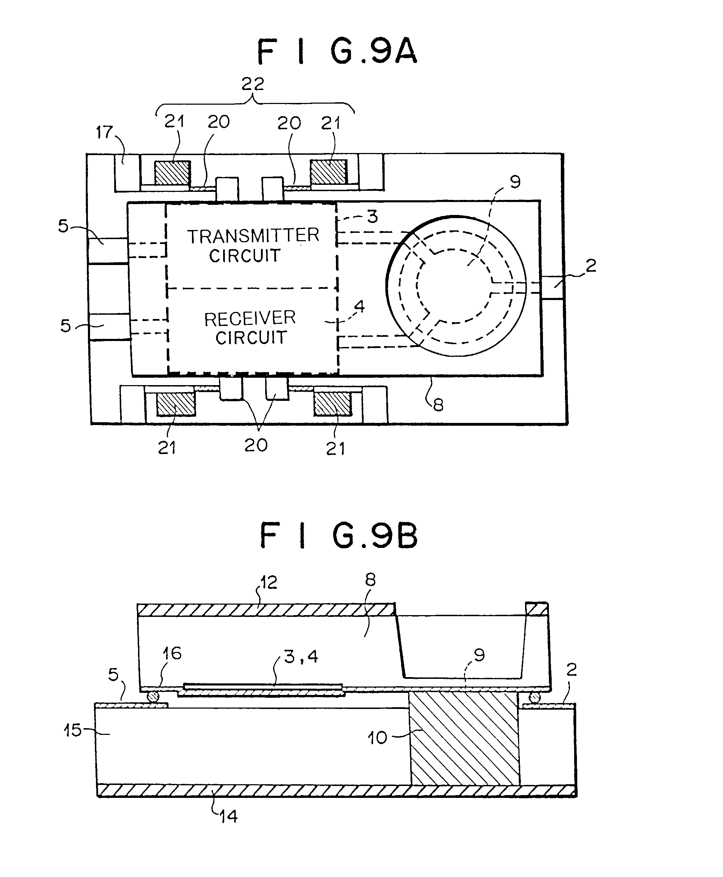

Figs. 9A and 9B are a plan view and a sectional view showing a fourth example of the structure of the microwave - millimeter wave circuit apparatus according to the second embodiment of the present invention. In the structure shown in Figs. 9A and 9B, a bias circuit 22 is formed on a dielectric substrate 15. The bias circuit 22 is composed of a resistor 20, a capacitor 21, and so forth. It is difficult to form a large capacitor in an MMIC. However, when a thin layer or a thick layer is formed on a ceramic substrate, a large capacitor can be easily formed. Thus, a stable bias circuit can be provided. The capacitor 21 and the resistor 20 remove a high frequency signal without the transmitted signal and received signal from a bias current supplied from a bias terminal 17. Thus, the capacitor 21 and the resistor 20 prevent a high frequency leakage from taking place in the transmitter circuit and the receiver circuit. Since only a bias line is formed on the MMIC, the circuit structure can be simplified.

### [Third Embodiment]

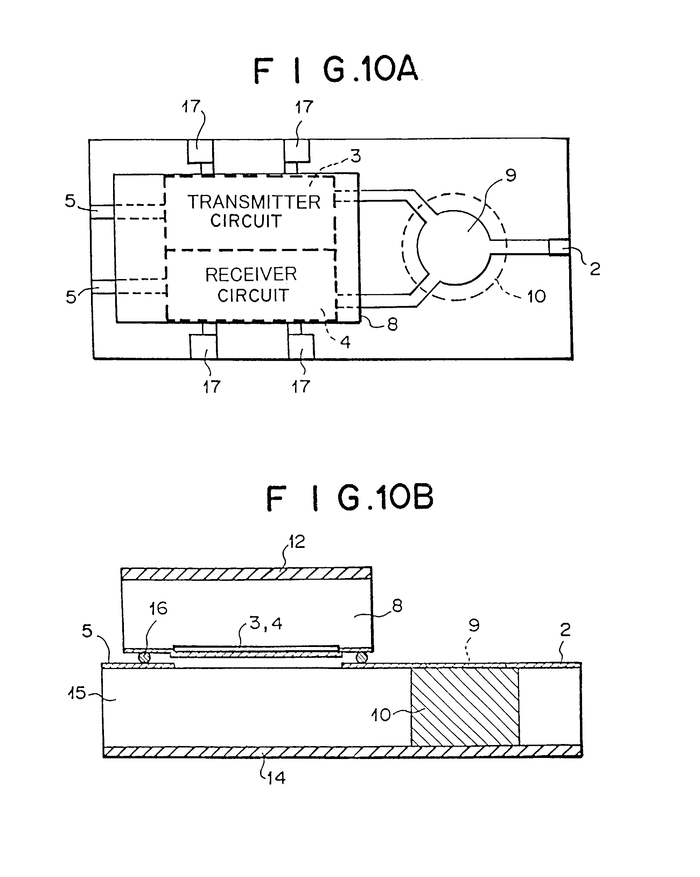

Figs. 10A and 10B are a plan view and a sectional view showing an example of the structure of a microwave - millimeter wave circuit apparatus according to a third embodiment of the present invention. In the structure shown in Figs. 10A and 10B, only a transmitter circuit and a receiver circuit are formed on an MMIC substrate 8. Patterns 2, 5, and 9 for a circulator and so forth and a bias terminal 17 are formed on a dielectric substrate 15. Ferrite 10 is embedded in the dielectric substrate 15. The MMIC substrate 8 and the dielectric substrate 15 are connected by flip-chip method. In the structure shown in Figs. 10A and 10B, since the patterns 2, 5, and 9 for the circulator and so forth and the bias terminal 17 are formed on the dielectric substrate 15, the MMIC substrate 8 can be compactly structured.

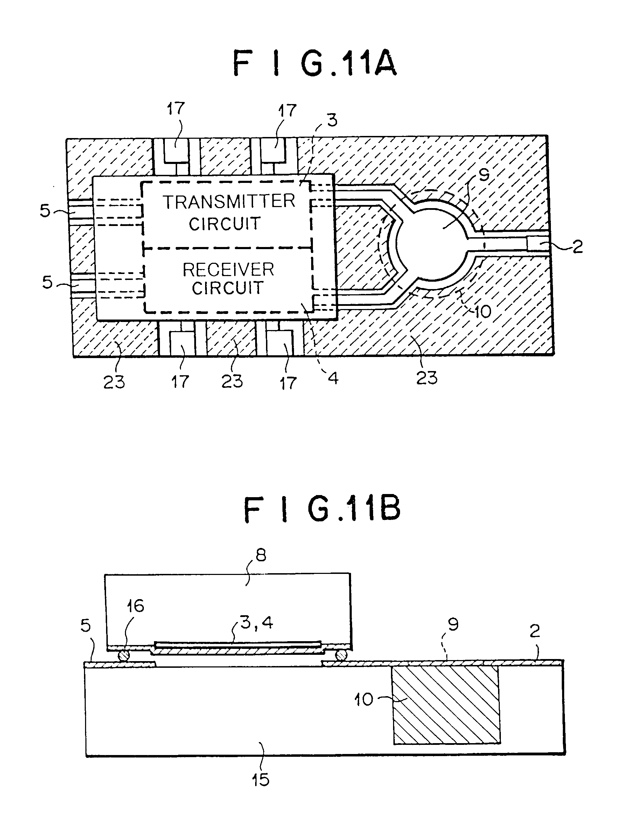

Figs. 11A and 11B are a plan view and a sectional view showing another example of the structure of the microwave - millimeter wave circuit apparatus according to the third embodiment of the present invention. In the structure shown in Figs. 11A and 11B, patterns for an MMIC and a circulator 4 are of coplanar type of which grounding electrodes 23 are formed. With the grounding electrodes 23, grounding conductors formed on a dielectric substrate 15 and an MMIC substrate 8 can be omitted.

### [Fourth Embodiment]

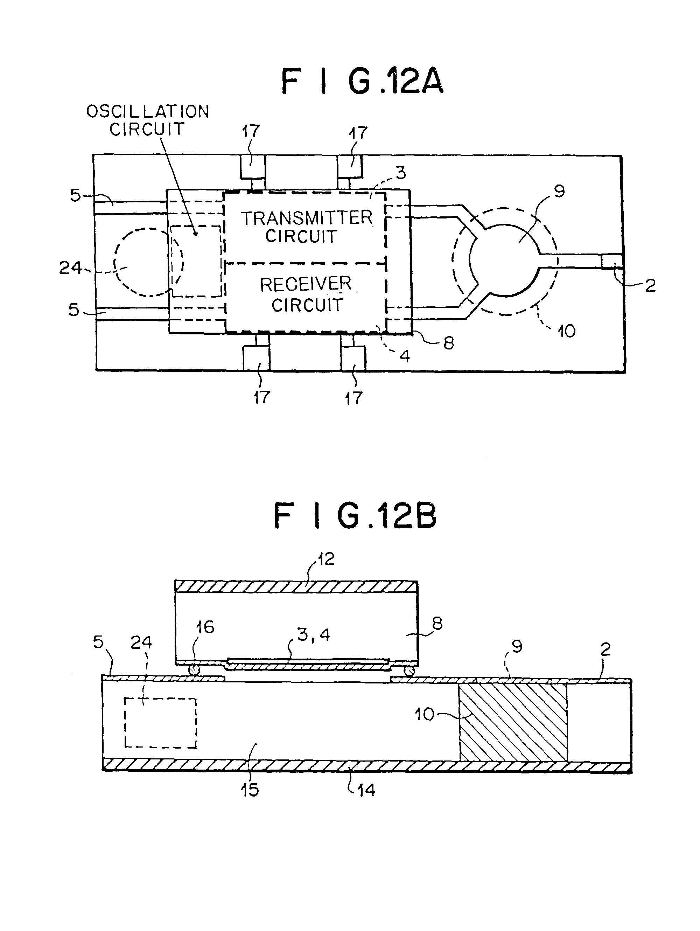

Figs. 12A and 12B are a plan view and a sectional view showing an example of the structure of a microwave - millimeter wave circuit apparatus according to a fourth embodiment of the present invention. In the structure shown in Figs. 12A and 12B, a dielectric resonator 24 is embedded in the dielectric substrate 15 according to the third embodiment shown in Figs. 11A and 11B. The dielectric resonator 24 is coupled with the oscillation circuit of the MMIC. The dielectric resonator 24 causes Q value of the oscillation circuit to become large. Thus, the oscillation circuit of the MMIC becomes stable. Consequently, the transmitter circuit 3, the receiver circuit 4, the highly stable (local) oscillation circuit, the circulator, and the bias circuit are integrally structured. Thus, a front end module that has high function, high performance, and high reliability can be accomplished rigidly and compactly. A circulator 9 is formed on a dielectric substrate 15. The dielectric resonator 24 for the oscillation circuit is embedded in the dielectric substrate 15. The dielectric substrate 15 has a bias terminal 17. Thus, the MMIC substrate 8 can be compactly structured.

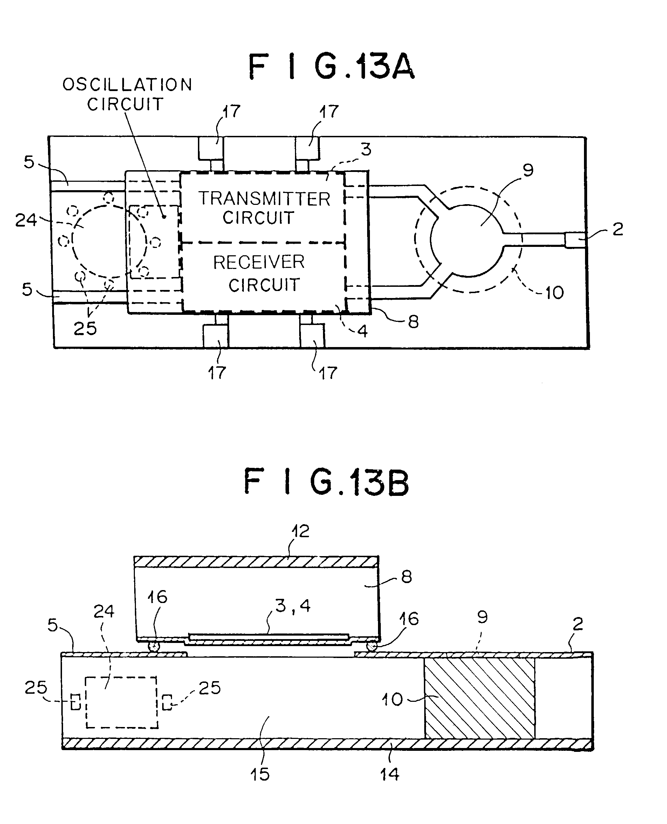

Figs. 13A and 13B are a plan view and a sectional view showing another example of the structure of the microwave - millimeter wave circuit apparatus according to the fourth embodiment of the present invention. In the structure shown in Figs. 13A and 13B, adjustment ferrite 25 as a tuning means of the oscillation frequency of the oscillation circuit is embedded around a dielectric resonator 24. Corresponding to the intensity of the magnetization of the ferrite, the intensity of the magnetic field around the dielectric resonator 24 is adjusted so as to turn the resonance frequency. When hard ferrite that has large self coercive force is used as the ferrite 25, by selectively magnetizing one of a plurality of ferrite portions, the magnetic field around the dielectric resonator 24 can be adjusted without an external magnetic field. Thus, the frequency can be easily adjusted.

According to the above-described embodiments, a circuit having an active device and a circulator 9 are integrally structured on the same substrate. Alternatively, the circulator 9 according to each of the above-described embodiments may be substituted into an isolator according to the circuit function.

### [Fifth Embodiment]

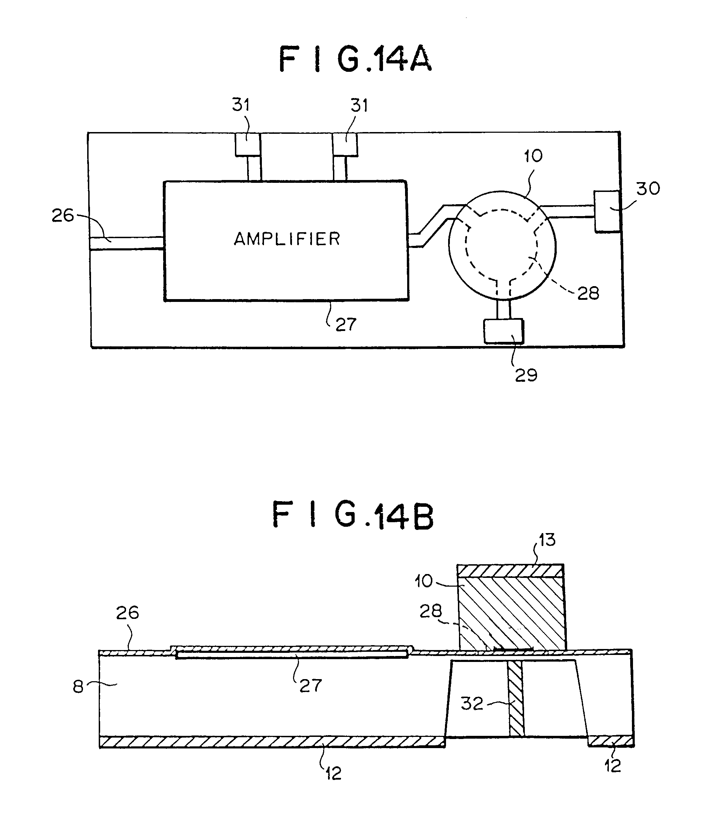

Figs. 14A and 14B are a plan view and a sectional view showing an example of the structure of a microwave - millimeter wave circuit apparatus according to a firth embodiment of the present invention. In the structure shown in Figs. 14A and 14B, an amplifier as a circuit having an active device is formed on an MMIC substrate 8. A pattern 28 for an isolator is formed on an output side of the amplifier. Ferrite 10 is disposed in such a manner that it contacts the pattern 28. A grounding metal 13 is formed on the lower surface of the ferrite 10. One terminal of the pattern 28 is connected to a non-reflection termination resistor 29. The grounding side of the non-reflection termination resistor 29 is connected to a grounding metal 12 on the other surface of the MMIC substrate 8 through a via-hole 32. An input signal received from a signal terminal 26 is amplified by an amplifier 27. An output signal of the amplifier 27 is supplied to a signal terminal 30 through the isolator. An output signal of the signal terminal 30 is supplied to the non-reflection termination terminal 29 that terminates the signal with a predetermined load impedance. Thus, the circuit shown in Figs. 14A and 14B has a function of uni-direction.

According to the above-described embodiments, the microwave - millimeter wave circuit apparatus is composed as it of micro-strip type. However, it should be noted that the microwave - millimeter wave circuit apparatus may be composed as it of tri-plate type or coplanar type. In addition, the structure composed of the MMIC substrate 8 and the dielectric substrate 15 is accomplished as a microwave - millimeter wave circuit apparatus having an isolator. In addition, a microwave - millimeter wave circuit apparatus according to the present invention may be accomplished as it of a combination with a circulator and an isolator.

According to the above-described embodiments, an MMIC substrate is used as a circuit substrate. However, the present invention is not limited to such a structure. For example, a hybrid circuit (substrate) having discrete transistors may be used. The dielectric substrate is not limited to a ceramic substrate such as an alumina substrate. Instead, an organic insulation layer such as PPE (polyphenylene ether) resin, fluorence skelton-containing epoxy acrylate resin or polyimide resin may be used. In addition, according to the above-described embodiments, a pattern for a circulator or isolator and ferrite are oppositely aligned in such a manner that the pattern contacts the circulator or isolator. However, the pattern for the circulator or isolator and the ferrite may be oppositely aligned through a layer or a small gap.

According to the above-described embodiments, the MMIC substrate is a two-dimensional MMIC on which circuits are formed on a semiconductor surface. Alternatively, a three-dimensional MMIC may be used. In the three-dimensional MMIC, a plurality of polyimide layers are formed on a semiconductor surface having transistors, resistors, IC devices, and so forth, fine lines and grounding conductors being formed on each of the layers, the layers being connected with via-holes.

As described above, in the microwave - millimeter wave circuit apparatus according to the present invention, a microwave - millimeter wave circuit and a pattern for a circulator or isolator having ferrite are integrally structured. Alternatively, a dielectric substrate in which ferrite that composes a circulator or isolator and a circuit substrate on which a microwave - millimeter wave circuit is formed are oppositely aligned and thereby integrally structured. Alternatively, a microwave - millimeter wave circuit including an oscillation circuit and a dielectric substrate in which ferrite composing a circulator or isolator and a dielectric resonator composing a resonance circuit are embedded are oppositely aligned. Thus, since the microwave - millimeter wave circuit, the resonance circuit, and the circulator or isolator are integrally structured. Consequently, unlike with the structure of a combination of discrete substrates, adjustments are not required. Thus, a microwave - millimeter wave front end module that is compact, fabricated at low cost, suitable for mass production, excellent in the reproducibility of the characteristic in fabrication, and rigid and that has high reliability can be easily accomplished.

According to the present invention, a front end module whose thickness is 1 mm or less and whose size is 2 x 3 mm or less can be accomplished in for example 76 GHz band.

Although the present invention has been shown and described with respect to a best mode embodiment thereof, it should be understood by those skilled in the art that the foregoing and various other changes, omissions, and additions in the form and detail thereof may be made therein without departing from the spirit and scope of the present invention.

## Claims

1. A microwave - millimeter wave circuit apparatus, comprising:
an MMIC (Monolithic Microwave Integrated Circuits) substrate having a pattern for one of a circulator and isolator; and
a microwave - millimeter wave circuit and the pattern being formed on said MMIC substrate,
wherein the pattern being connected to said microwave - millimeter wave circuit on said MMIC substrate.

2. A microwave - millimeter wave circuit apparatus, comprising:
a circuit substrate having a microwave - millimeter wave circuit formed thereon;
a pattern for one of a circulator and isolator connected to the microwave - millimeter wave circuit; and
a ferrite composing one of the circulator and isolator contacting the pattern,
wherein said pattern is formed on said circuit substrate.

3. A microwave - millimeter wave circuit apparatus, comprising:
a dielectric substrate having ferrite composing one of a circulator and isolator, the ferrite being embedded in said dielectric substrate; and
a circuit substrate having a microwave - millimeter wave circuit formed thereon,
wherein said dielectric substrate and said circuit substrate are oppositely aligned in such a manner that the microwave -millimeter wave circuit and one of the circulator and isolator are integrally structured.

4. A microwave - millimeter wave circuit apparatus, comprising:
a circuit substrate having a microwave - millimeter wave circuit including an oscillation circuit, the microwave - millimeter wave circuit being formed on said circuit substrate; and
a dielectric substrate having ferrite and a dielectric resonator embedded therein, the ferrite composing one of a circulator and isolator, the dielectric resonator being a resonating circuit,
wherein said circuit substrate and said dielectric substrate are oppositely aligned in such a manner that the microwave -millimeter wave circuit, the resonating circuit, and one of the circulator and isolator are integrally structured.

5. The microwave - millimeter wave circuit apparatus as set forth in claim 4,
wherein the ferrite is embedded around the dielectric resonator, the resonance frequency of the dielectric resonator being adjusted by varying the magnetization of the ferrite.

6. The microwave - millimeter wave circuit apparatus as set forth in any one of claims 3 to 5,
wherein said dielectric substrate has a signal terminal.

7. The microwave - millimeter wave circuit apparatus as set forth in any one of claims 3 to 5,
wherein said circuit substrate has a signal terminal.

8. The microwave - millimeter wave circuit apparatus as set forth in any one of claims 3 to 5,
wherein said dielectric substrate has a bias circuit.

9. The microwave - millimeter wave circuit apparatus as set forth in any one of claims 3 to 8,
wherein said circuit substrate and said dielectric substrate are connected with bumps.

10. The microwave - millimeter wave circuit apparatus as set forth in any one of claims 3 to 9,
wherein said circuit substrate is secured to said dielectric substrate with resin.

11. The microwave - millimeter wave circuit apparatus as set forth in any one of claims 3 to 10,
wherein the pattern for one of the circulator and isolator is formed on said circuit substrate, the ferrite contacting the pattern.

12. The microwave - millimeter wave circuit apparatus as set forth in any one of claims 3 to 10,
wherein the pattern for one of the circulator and isolator is formed on the ferrite.

13. The microwave - millimeter wave circuit apparatus as set forth in any one of claims claims 3 to 12,
wherein the ferrite is hard ferrite.

14. A method for fabricating a microwave - millimeter wave circuit apparatus, comprising the steps of:
forming a microwave - millimeter wave circuit having a pattern for one of a circulator and isolator on a first surface of an MMIC (Monolithic Microwave Integrated Circuits) substrate;
forming a ferrite layer in such a manner that the ferrite layer contacts the pattern for one of one circulator and isolator; and
forming a grounding metal layer on a second surface of the MMIC substrate.
